# EUROPEAN PATENT APPLICATION

(11) **EP 4 507 009 A2**
(43) Date of publication of application: **12.02.2025**
(21) Application number: 24155656.2
(22) Date of filing: 20.02.2024
(51) Int. Cl.: H01L 29/778, H01L 29/423, H01L 29/06, H01L 29/417, H01L 29/20

(54) **SEMICONDUCTOR DEVICE**

(30) Priority: 10.08.2023 JP 2023131140
(71) Applicant: Kabushiki Kaisha Toshiba, Tokyo 105-0023 (JP); Toshiba Electronic Devices & Storage Corporation, Tokyo 105-0023 (JP)
(72) Inventor: KAJIWARA, Yosuke, Tokyo (JP); ONO, Hiroshi, Tokyo (JP)
(74) Representative: Kramer Barske Schmidtchen Patentanwälte PartG mbB

(57) **Abstract**

According to one embodiment, a semiconductor device includes a first electrode (51), a second electrode (52), a third electrode (53), a first semiconductor member, a second semiconductor member, a first insulating member, and a second insulating member. The first to third electrodes extend along a first direction (D1). The third electrode includes a first electrode portion (53a). The first semiconductor member includes Alₓ₁Ga₁₋ₓ₁N (0 ≤ x1 < 1). The first semiconductor member includes a first partial region, a second partial region, a third partial region, a fourth partial region, a fifth partial region, and a sixth partial region. The second semiconductor member includes Alₓ₂Ga₁₋ₓ₂N (0 < x2 ≤ 1, x1 < x2). The second semiconductor member includes a first semiconductor portion, a second semiconductor portion and a third semiconductor portion. The first insulating member includes a first insulating portion. The second insulating member includes a first insulating region.

## Description

### FIELD

Embodiments described herein generally relate to a semiconductor device.

### BACKGROUND

For example, semiconductor devices such as transistors are desired to have improved characteristics.

### BRIEF DESCRIPTION OF THE DRAWINGS

FIG. 1 is a schematic plan view illustrating a semiconductor device according to a first embodiment;
FIG. 2 is a schematic cross-sectional view illustrating the semiconductor device according to the first embodiment;
FIG. 3 is a schematic cross-sectional view illustrating the semiconductor device according to the first embodiment;
FIG. 4 is a schematic plan view illustrating the semiconductor device according to the first embodiment;
FIG. 5 is a schematic plan view illustrating a semiconductor device according to the first embodiment;
FIG. 6 is a schematic plan view illustrating a semiconductor device according to the first embodiment;
FIG. 7 is a schematic plan view illustrating a semiconductor device according to a second embodiment;
FIG. 8 is a schematic cross-sectional view illustrating the semiconductor device according to the second embodiment;
FIG. 9 is a schematic cross-sectional view illustrating the semiconductor device according to the second embodiment;
FIG. 10 is a schematic cross-sectional view illustrating the semiconductor device according to the second embodiment;
FIG. 11 is a schematic cross-sectional view illustrating the semiconductor device according to the second embodiment;
FIG. 12 is a schematic cross-sectional view illustrating the semiconductor device according to the second embodiment;
FIG. 13 is a schematic cross-sectional view illustrating the semiconductor device according to the second embodiment;
FIG. 14 is a schematic plan view illustrating a semiconductor device according to the second embodiment;
FIG. 15 is a schematic plan view illustrating a semiconductor device according to the second embodiment;
FIG. 16 is a schematic plan view illustrating a semiconductor device according to an embodiment; and
FIG. 17 is a schematic plan view illustrating a semiconductor device according to an embodiment.

### DETAILED DESCRIPTION

According to one embodiment, a semiconductor device includes a first electrode, a second electrode, a third electrode, a first semiconductor member, a second semiconductor member, a first insulating member, and a second insulating member. The first electrode extends along a first direction. The second electrode extends along the first direction. A second direction from the first electrode to the second electrode crosses the first direction. The third electrode extends along the first direction. A position of the third electrode in the second direction is between a position of the first electrode in the second direction and a position of the second electrode in the second direction. The third electrode includes a first electrode portion. The first semiconductor member includes Alₓ₁Ga₁₋ₓ₁N(0 ≤ x1 < 1). The first semiconductor member includes a first partial region, a second partial region, a third partial region, a fourth partial region, a fifth partial region, and a sixth partial region. A direction from the first partial region to the first electrode is along a third direction crossing a plane including the first direction and the second direction. A direction from the second partial region to the second electrode is along the third direction. A direction from the third partial region to the first electrode portion is along the third direction. A position of the fourth partial region in the second direction is between a position of the first partial region in the second direction and a position of the third partial region in the second direction. A position of the fifth partial region in the second direction is between the position of the third partial region in the second direction and a position of the second partial region in the second direction. A direction from the third partial region to the sixth partial region is along the first direction. The second semiconductor member includes Alₓ₂Ga₁₋ₓ₂N (0 < x2 ≤ 1, x1 < x2). The second semiconductor member includes a first semiconductor portion, a second semiconductor portion and a third semiconductor portion. A direction from the fourth partial region to the first semiconductor portion is along the third direction. A direction from the fifth partial region to the second semiconductor portion is along the third direction. A direction from the sixth partial region to the third semiconductor portion is along the third direction. The first electrode portion is provided between the first semiconductor portion and the second semiconductor portion in the second direction. A direction from the first electrode portion to the third semiconductor portion is along the first direction. The first insulating member includes a first insulating portion. The first insulating portion is provided between the third partial region and the first electrode portion, between the first semiconductor portion and the first electrode portion, and between the first electrode portion and the second semiconductor portion. The second insulating member includes a first insulating region. The first insulating region is provided between the third electrode and the third semiconductor portion in the first direction.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously in an antecedent drawing are marked with like reference numerals, and a detailed description is omitted as appropriate.

### (First Embodiment)

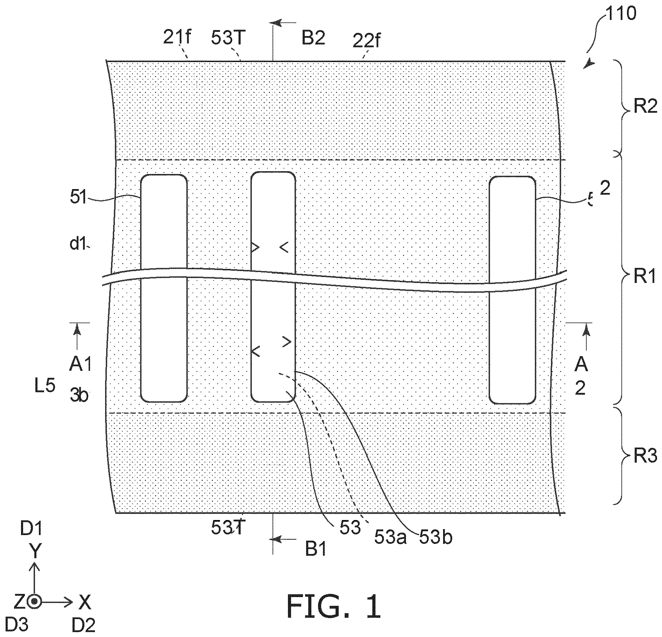

FIG. 1 is a schematic plan view illustrating a semiconductor device according to a first embodiment.

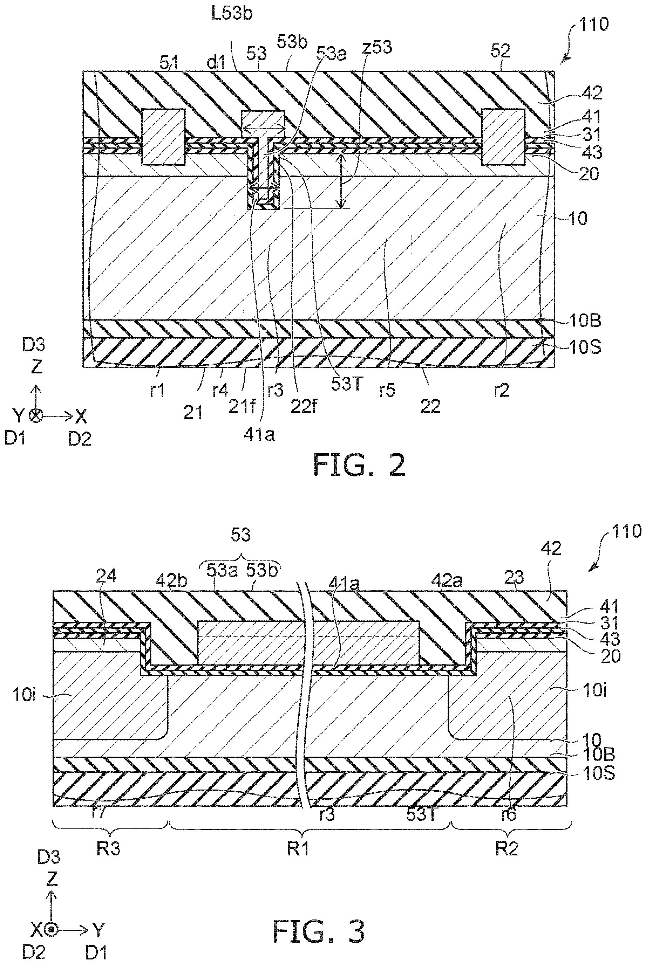

FIGS. 2 and 3 are schematic cross-sectional views illustrating the semiconductor device according to the first embodiment.

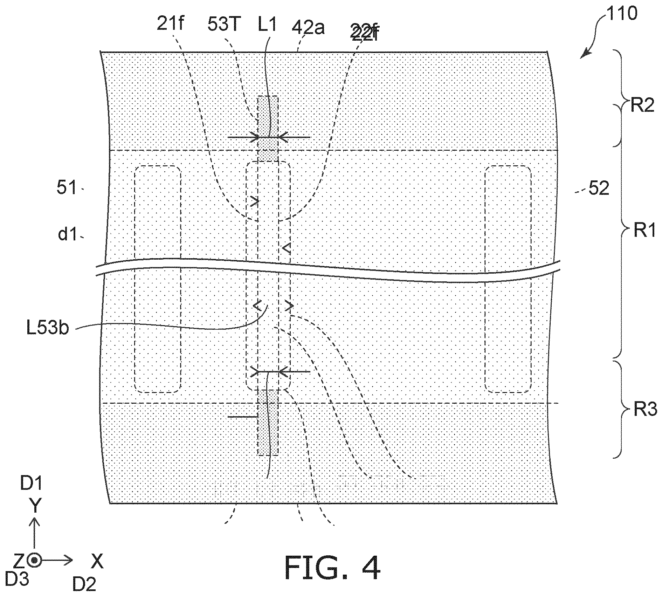

FIG. 4 is a schematic plan view illustrating the semiconductor device according to the first embodiment.
FIG. 2 is a cross-sectional view taken along line the A1-A2 of FIG. 1. FIG. 3 is a cross-sectional view taken along the line B1-B2 of FIG. 1.

As shown in FIGS. 1 to 3, a semiconductor device 110 according to the embodiment includes a first electrode 51, a second electrode 52, a third electrode 53, a first semiconductor member 10, a second semiconductor member 20, and a first insulating member 41 , and a second insulating member 42.

The first electrode 51, the second electrode 52 and the third electrode 53 extend along a first direction D1. The first direction D1 is defines as a Y-axis direction. One direction perpendicular to the Y-axis direction is defined as an X-axis direction. A direction perpendicular to the Y-axis direction and the X-axis direction is defined as a Z-axis direction. In each of these electrodes, the length in the Y-axis direction is longer than the length in the X-axis direction and longer than the length in the Z-axis direction.

A second direction D2 from the first electrode 51 to the second electrode 52 crosses the first direction D1. The second direction D2 is, for example, the X-axis direction.

A position of the third electrode 53 in the second direction D2 is between a position of the first electrode 51 in the second direction D2 and a position of the second electrode 52 in the second direction D2. The third electrode 53 includes a first electrode portion 53a. The first electrode portion 53a extends along the first direction D1.

The first semiconductor member 10 includes Alₓ₁Ga₁₋ₓ₁N(0 < x1 < 1). The composition ratio x1 may be, for example, not less than 0 and less than 0.13. The first semiconductor member 10 may be GaN or AlGaN.

The first semiconductor member 10 includes a first partial region r1, a second partial region r2, a third partial region r3, a fourth partial region r4, a fifth partial region r5, and a sixth partial region r6. A direction from the first partial region r1 to the first electrode 51 is along a third direction D3. The third direction D3 crosses a plane including the first direction D1 and the second direction D2. The third direction D3 is, for example, the Z-axis direction.

A direction from the second partial region r2 to the second electrode 52 is along the third direction D3. A direction from the third partial region r3 to the first electrode portion 53a is along the third direction D3. A position of the fourth partial region r4 in the second direction D2 is between a position of the first partial region r1 in the second direction D2 and a position of the third partial region r3 in the second direction D2. A position of the fifth partial region r5 in the second direction D2 is between the position of the third partial region r3 in the second direction D2 and a position of the second partial region r2 in the second direction D2. A direction from the third partial region r3 to the sixth partial region r6 is along the first direction D1 (see FIG. 3).

The second semiconductor member 20 includes Alₓ₂Ga₁₋ₓ₂N (0 < x2 ≤ 1, x1 < x2). The composition ratio x2 may be, for example, not less than 0.13 and not more than 0.4. The second semiconductor member 20 includes, for example, AlGaN.

As shown in FIG. 2, the second semiconductor member 20 includes a first semiconductor portion 21 and a second semiconductor portion 22. A direction from the fourth partial region r4 to the first semiconductor portion 21 is along the third direction D3. A direction from the fifth partial region r5 to the second semiconductor portion 22 is along the third direction D3.

As shown in FIG. 3, the second semiconductor member 20 further includes a third semiconductor portion 23. A direction from the sixth partial region r6 to the third semiconductor portion 23 is along the third direction D3. As shown in FIG. 2, the first electrode portion 53a is provided between the first semiconductor portion 21 and the second semiconductor portion 22 in the second direction D2. As shown in FIG. 3, a direction from the first electrode portion 53a to the third semiconductor portion 23 is along the first direction D1.

The first insulating member 41 includes a first insulating portion 41a. As shown in FIGS. 2 and 3, the first insulating portion 41a is provided between the third partial region r3 and the first electrode portion 53a, between the first semiconductor portion 21 and the first electrode portion 53a, and between the first electrode portion 53a and the second semiconductor portion 22.

As shown in FIG. 3, the second insulating member 42 includes a first insulating region 42a. The first insulating region 42a is provided between the third electrode 53 and the third semiconductor portion 23 in the first direction D1.

In the semiconductor device 110, a current flowing between the first electrode 51 and the second electrode 52 can be controlled by a potential of the third electrode 53. The potential of the third electrode 53 may be based on a potential of the first electrode 51. The first electrode 51 functions, for example, as a source electrode. The second electrode 52 functions, for example, as a drain electrode. The third electrode 53 functions as, for example, a gate electrode. The semiconductor device 110 is, for example, a transistor.

The first semiconductor member 10 includes a portion facing the second semiconductor member 20. A carrier region is formed in this portion. The carrier region is, for example, a two-dimensional electron gas. The semiconductor device 110 is, for example, a HEMT (High Electron Mobility Transistor).

For example, a distance between the first electrode 51 and the third electrode 53 is shorter than a distance between the third electrode 53 and the second electrode 52. It is easy to obtain stable operation.

In the semiconductor device 110, the first electrode portion 53a of the third electrode 53 is provided between the first semiconductor portion 21 and the second semiconductor portion 22. The first electrode portion 53a is provided, for example, in a trench 53T (or recess) provided in the semiconductor member. This makes it easy to obtain a high threshold. For example, normally-off operation is obtained. In the semiconductor device 110, the first electrode portion 53a may be provided between the fourth partial region r4 and the fifth partial region r5.

As described above, in the embodiment, the first insulating region 42a is provided between the third electrode 53 and the third semiconductor portion 23. Thereby, leakage current can be suppressed.

For example, a first reference example may be considered in which the first insulating region 42a is not provided. In the first reference example, current easily flows between the first semiconductor portion 21 and the second semiconductor portion 22 via the third semiconductor portion 23. Leakage current occurs. This makes it difficult to sufficiently lower the off-resistance.

In contrast, in the embodiment, by providing the first insulating region 42a, leakage current can be suppressed. This provides, for example, normally-off operation with sufficiently low off-resistance. For example, leakage current can be suppressed by not overlapping the third electrode 53 with the third semiconductor portion 23 in the Z-axis direction. This provides normally-off operation with sufficiently low off-resistance. According to the embodiment, a semiconductor device with improved characteristics can be provided.

For example, as shown in FIG. 1, the semiconductor device 110 may include a first region R1, a second region R2 and a third region R3. The first region R1 is provided between the second region R2 and the third region R3 in the first direction D1. The first region R1 is an active region. The second region R2 is one of the plurality of terminal regions. The third region R3 is another one of the plurality of terminal regions.

The first partial region r1, the second partial region r2, the third partial region r3, the fourth partial region r4, and the fifth partial region r5 are included in the first region R1. The sixth partial region r6 is included in the second region R2. A crystallinity of the first region R1 is higher than a crystallinity of the second region R2. Alternatively, the first region R1 includes crystal and the second region R2 does not include crystal. The second region R2 is formed, for example, by implanting ions such as Ar into the semiconductor member to deteriorate the crystallinity of the semiconductor member. The first region R1 is a region into which ions are not implanted. A concentration of the first element in the second region R2 is higher than a concentration of the first element in the first region R1. The first element includes at least one selected from the group consisting of Ar, P and N.

For example, a second reference example can be considered in which an end of the third electrode 53 is provided in the second region R2. In this case, a part of the second region R2 is covered with the third electrode 53. Ions are not implanted into the portion covered with the third electrode 53, and high crystallinity is maintained. This portion has high conductivity and serves as a path for leakage current.

For example, when the second region R2 includes a portion not covered by the third electrode 53 and ions are implanted into this portion, the crystallinity may be recovered by subsequent heat treatment. In this case as well, a leakage current path exists.

As shown in FIG. 3, in the embodiment, the end of the third electrode 53 is located in the first region R1. The portion not covered by the third electrode 53 is not provided in the second region R2, which is the termination region. For example, in the first direction D1, the end of the third electrode 53 recessed from the end of the trench 53T. As a result, a portion where the second semiconductor member 20 is not provided is formed in the second region R2 of the termination region. When ions are implanted into this portion, a highly crystalline region is not formed in the second region R2 of the termination region. A carrier region is not formed in the second region R2. The first insulating region 42a is provided in a portion where the third electrode 53 is recessed. The current path is surely divided.

For example, as shown in FIG. 3, the second region R2 includes a high resistance region 10i. The high resistance region 10i is a region into which ions such as Ar are implanted. The sixth partial region r6 and the third semiconductor portion 23 are included in the high resistance region 10i. The crystallinity in these regions included in the high resistance region 10i is lower than the crystallinity in the region (first region R1) not included in the high resistance region 10i.

For example, a crystallinity of the first semiconductor portion 21 is higher than a crystallinity of the third semiconductor portion 23. Alternatively, the first semiconductor portion 21 includes crystal, and the third semiconductor portion 23 does not include crystal.

For example, a crystallinity of the fourth partial region r4 is higher than a crystallinity of the sixth partial region r6. Alternatively, the fourth partial region r4 include crystal and the sixth partial region r6 does not include crystal. For example, a crystallinity of the fifth partial region r5 is higher than the crystallinity of the sixth partial region r6. Alternatively, the fifth partial region r5 includes crystal and the sixth partial region r6 does not include crystal.

As shown in FIG. 3, the first semiconductor member 10 may further include a seventh partial region r7. The third partial region r3 is provided between the seventh partial region r7 and the sixth partial region r6 in the first direction D1. The second semiconductor member 20 may further include a fourth semiconductor portion 24. The first electrode portion 53a is provided between the fourth semiconductor portion 24 and the third semiconductor portion 23 in the first direction D1. The second insulating member 42 may further include a second insulating region 42b. The second insulating region 42b is provided between the fourth semiconductor portion 24 and the third electrode 53 in the first direction D1.

The third region R3 is, for example, a region into which ions such as Ar are implanted. The seventh partial region r7 and the fourth semiconductor portion 24 are included in the third region R3. The crystallinity of the seventh partial region r7 and the fourth semiconductor portion 24 included in the third region R3 is lower than the crystallinity of the portion included in the first region R1.

For example, as shown in FIG. 3, the third region R3 includes the high resistance region 10i. The high resistance region 10i is a region into which ions such as Ar are implanted. The seventh partial region r7 and the fourth semiconductor portion 24 are included in the high resistance region 10i. The crystallinity in these regions included in the high resistance region 10i is lower than the crystallinity in the region (first region R1) not included in the high resistance region 10i.

For example, the crystallinity of the first semiconductor portion 21 is higher than a crystallinity of the fourth semiconductor portion 24. Alternatively, the first semiconductor portion 21 includes crystal, and the fourth semiconductor portion 24 does not include crystal.

The crystallinity of the fourth partial region r4 is higher than the crystallinity of the seventh partial region r7. Alternatively, the fourth partial region r4 includes crystal, and the seventh partial region r7 does not include crystal. The crystallinity of the fifth partial region r5 is higher than the crystallinity of the seventh partial region r7. Alternatively, the fifth partial region r5 includes crystal, and the seventh partial region r7 does not include crystal.

Thus, the crystallinity of the first region R1 is higher than the crystallinity of the third region R3. Alternatively, the first region R1 includes crystal and the third region R3 does not include crystal.

As shown in FIG. 1, the third electrode 53 does not overlap the second region R2 in the third direction D3, and does not overlap the third region R3 in the third direction D3. In this example, the second electrode 52 does not overlap the second region R2 in the third direction D3, and does not overlap the third region R3 in the third direction D3. For example, the first electrode 51 does not overlap the second region R2 in the third direction D3, and does not overlap the third region R3 in the third direction D3.

As shown in FIGS. 2 and 3, the semiconductor device 110 may further include a first compound member 31. The first compound member 31 includes Al_{z1}Ga_{1-z1}N (0 < z1 ≤ 1, x2 < z1). The composition ratio z1 may be, for example, not more than 0.7 and not more than 1. The first compound member 31 includes, for example, AlN or AlGaN.

At least a part of the first compound member 31 is provided between the third partial region r3 and the first insulating portion 41a, between the first semiconductor portion 21 and the first insulating portion 41a, and between the first insulating portion 41a and the second semiconductor portion 22. By providing the first compound member 31, for example, high mobility is easily obtained. The resistance of the semiconductor device 110 can be lowered. In the first reference example in which the first insulating region 42a is not provided, when the first compound member 31 is provided, the current leakage tends to increase. By providing the first insulating region 42a, the current leakage can be effectively reduced even when the first compound member 31 is provided. High mobility and small leakage current are easily obtained.

As shown in FIG. 2, the semiconductor device 110 may further include a third insulating member 43. The first semiconductor portion 21 is provided between the fourth partial region r4 and a part of the third insulating member 43. The second semiconductor portion 22 is provided between the fifth partial region r5 and a part of the third insulating member 43. The third semiconductor portion 23 is provided between the sixth partial region r6 and a part of the third insulating member 43. The fourth semiconductor portion 24 is provided between the seventh partial region r7 and a part of the third insulating member 43. The third insulating member 43 is provided between the second semiconductor member 20 and the first insulating member 41. The third insulating member 43 includes, for example, silicon and at least one selected from the group consisting of oxygen and nitrogen. The third insulating member 43 functions as a protective film of the second semiconductor member 20, for example. Current collapse is suppressed.

For example, the first insulating member 41 and the second insulating member 42 may include silicon and oxygen. The first insulating member 41 and the second insulating member 42 may include, for example, at least one selected from the group consisting of silicon and aluminum, and at least one selected from the group consisting of oxygen and nitrogen.

As shown in FIG. 2, the first semiconductor portion 21 includes a first side face 21f facing the first electrode portion 53a. The second semiconductor portion 22 includes a second side face 22f facing the first electrode portion 53a. The first side face 21f and the second side face 22f correspond to the side faces of the trench 53T.

As shown in FIGS. 1 and 2, the third electrode 53 may include a second electrode portion 53b. The first electrode portion 53a is provided between the third partial region r3 and the second electrode portion 53b. A length of the second electrode portion 53b in the second direction D2 (second electrode portion length L53b) may be longer than a first distance d1 in the second direction D2 between the first side face 21f and the second side face 22f. In the third direction D3, a part of the first insulating member 41 may be provided between a part of the second semiconductor member 20 and the second electrode portion 53b.

As shown in FIG. 4, the planar shape of the first insulating region 42a and the second insulating region 42b may be along the planar shape of the trench 53T. A first width L1 of the first insulating region 42a along the second direction D2 may be substantially the same as the first distance d1. A second width L2 of the second insulating region 42b along the second direction D2 may be substantially the same as the first distance d1. The first width L1 is shorter than the second electrode portion length L53b. The second width L2 is shorter than the second electrode portion length L53b.

A depth z53 (see FIG. 2) of the trench 53T may be, for example, not less than 100 nm and not more than 400 nm. The depth z53 of the trench 53T corresponds to a distance along the third direction D3 between the interface between the third partial region r3 and the first compound member 31 and the interface between the second semiconductor member 20 and the third insulating member 43. When the depth z53 of the trench 53T is 100 nm or more, the current leakage can be effectively suppressed. It is easy to obtain a high threshold voltage. When the depth z53 of the trench 53T is 400 nm or less, the on-resistance of the semiconductor device 110 is easily lowered.

It is notable that the distance along the third direction D3 between the third partial region r3 and the first electrode portion 53a is, for example, not less than 20 nm and not more than 150 nm. Highly stable operation can be obtained. When the distance is 20 nm or more, it is easy to obtain stable operation with a threshold voltage, for example. When the distance is 150 nm or less, it is easy to obtain low on-resistance, for example.

As shown in FIG. 2, in this example, the semiconductor device 110 includes a substrate 10S and a nitride member 10B. The nitride member 10B is provided between the substrate 10S and the first semiconductor member 10. The substrate 10S may be, for example, a silicon substrate. The nitride member 10B may include, for example, Al, Ga, and nitrogen. The nitride member 10B is, for example, a buffer layer.

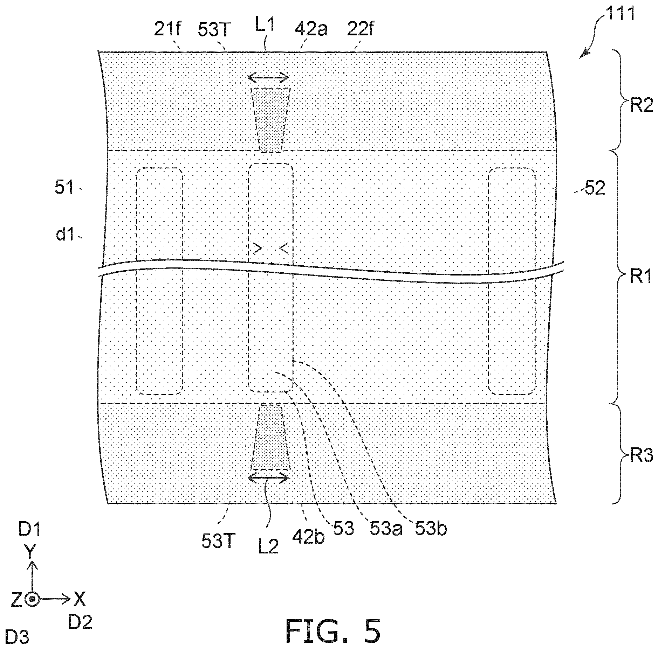

FIG. 5 is a schematic plan view illustrating a semiconductor device according to the first embodiment.

As shown in FIG. 5, in a semiconductor device 111, the shapes of the first insulating region 42a and the second insulating region 42b are different from those in the semiconductor device 110. The configuration of the semiconductor device 111 other than this may be the same as the configuration of the semiconductor device 110. The planar shapes of the first insulating region 42a and the second insulating region 42b may be trapezoids, for example. These planar shapes may be rectangular, for example.

As previously described with respect to FIG. 2, the first semiconductor portion 21 includes the first side face 21f facing the first electrode portion 53a. The second semiconductor portion 22 includes the second side face 22f facing the first electrode portion 53a. As shown in FIGS. 2 and 5, the distance along the second direction D2 between the first side face 21f and the second side face 22f is the first distance d1.

As shown in FIG. 5, in the semiconductor device 111, the first distance d1 is narrower than the first width L1 along the second direction D2 of at least a part of the first insulating region 42a. The first distance d1 is narrower than the second width L2 in the second direction D2 of at least a part of the second insulating region 42b. By the first width L1 being wide and the second width L2 being wide, the current path is more surely divided.

Each of the first width L1 and the second width L2 is preferably not less than 1.5 times and not more than 10 times the first distance d1.

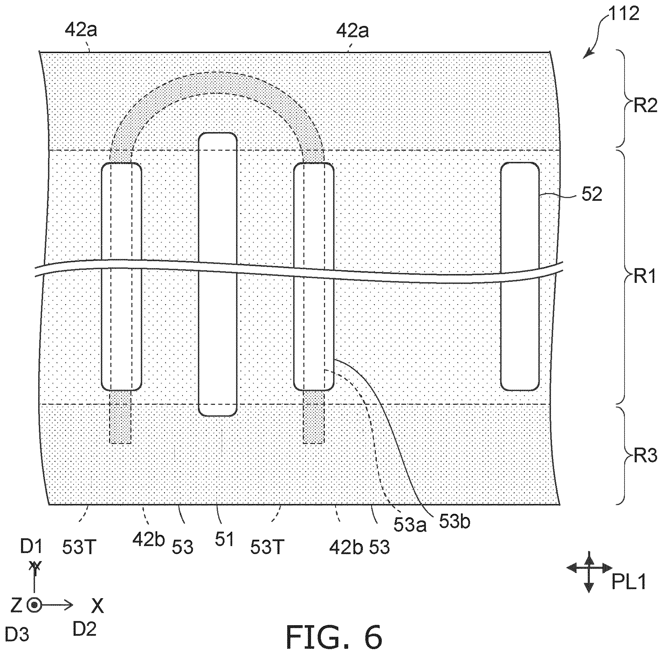

FIG. 6 is a schematic plan view illustrating a semiconductor device according to the first embodiment.

As shown in FIG. 6, in a semiconductor device 112, a plurality of third electrodes 53 are provided. Except for this, the configuration of the semiconductor device 112 may be the same as the configuration of the semiconductor device 110.

As shown in FIG. 6, a plurality of first insulating regions 42a are provided corresponding to the plurality of third electrodes 53. A direction from one of the plurality of third electrodes 53 to one of the plurality of first insulating regions 42a is along the first direction D1. A direction from another one of the plurality of third electrodes 53 to another one of the plurality of first insulating regions 42a is along the first direction D1. In a first plane PL1 including the first direction D1 and the second direction D2, one of the plurality of first insulating regions 42a is continuous with another one of the plurality of first insulating regions 42a.

For example, in the second region R2, the current path between the first electrode 51 and the second electrode 52 is more surely divided.

### (Second Embodiment)

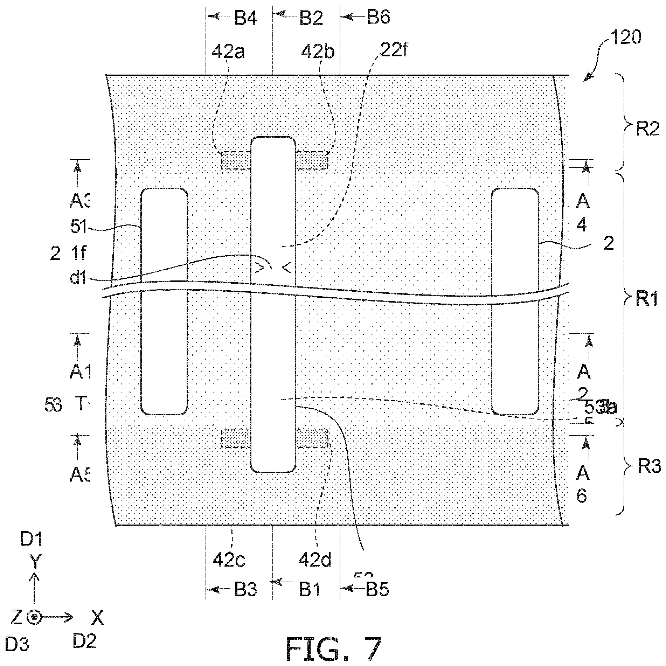

FIG. 7 is a schematic plan view illustrating a semiconductor device according to a second embodiment.

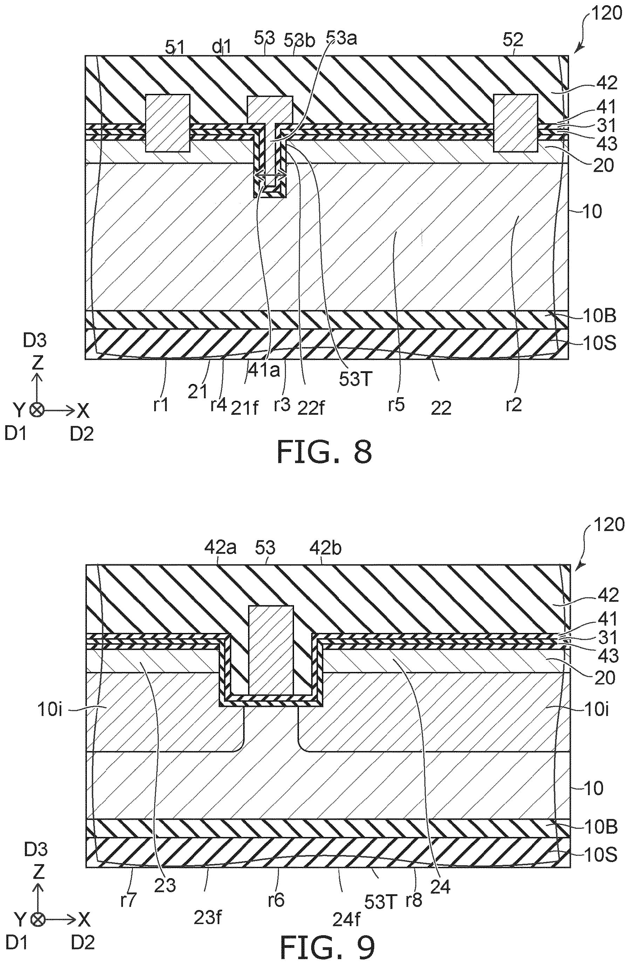

FIGS. 8 to 13 are schematic cross-sectional views illustrating the semiconductor device according to the second embodiment.

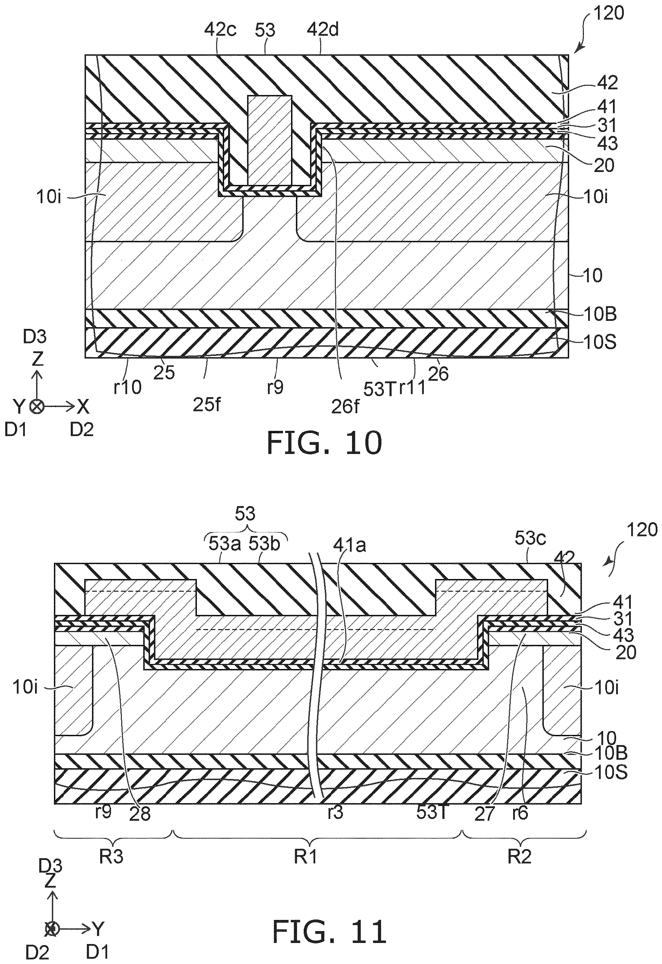

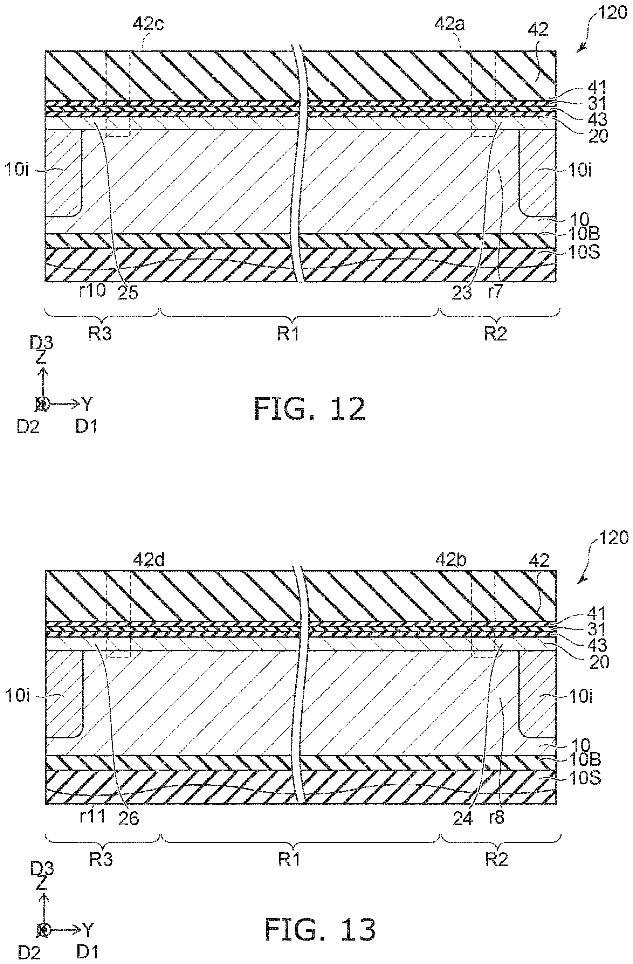

FIG. 8 is a cross-sectional view taken along the line A1-A2 of FIG. 7. FIG. 9 is a sectional view taken along the line A3-A4 in FIG. 7. FIG. 10 is a sectional view taken along the line A5-A6 in FIG.7. FIG. 11 is a sectional view taken along the line B1-B2 in FIG. 7. FIG. 12 is a sectional view taken along the line B3-B4 in FIG. 7. FIG. 13 is a sectional view taken along the line B5-B6 in FIG. 7.

As shown in FIGS. 7 to 12, a semiconductor device 120 according to the embodiment includes the first electrode 51, the second electrode 52, the third electrode 53, the first semiconductor member 10, the second semiconductor member 20, and the first insulating member. 41 and the second insulating member 42.

The first electrode 51, the second electrode 52, and the third electrode 53 extend along the first direction D1. The second direction D2 from the first electrode 51 to the second electrode 52 crosses the first direction D1. The position of the third electrode 53 in the second direction D2 is between the position of the first electrode 51 in the second direction D2 and the position of the second electrode 52 in the second direction D2. The third electrode 53 includes the first electrode portion 53a.

The first semiconductor member 10 includes Alₓ₁Ga₁₋ₓ₁N(0 < x1 < 1). The first semiconductor member 10 includes the first partial region r1, the second partial region r2, the third partial region r3, the fourth partial region r4, the fifth partial region r5, the sixth partial region r6 and the seventh partial region r7.

As shown in FIG. 8, the direction from the first partial region r1 to the first electrode 51 is along the third direction D3 that crosses the plane including the first direction D1 and the second direction D2. The direction from the second partial region r2 to the second electrode 52 is along the third direction D3. The direction from the third partial region r3 to the first electrode portion 53a is along the third direction D3.

As shown in FIG. 8, the position of the fourth partial region r4 in the second direction D2 is between the position of the first partial region r1 in the second direction D2 and the position of the third partial region r3 in the second direction D2. The position of the fifth partial region r5 in the second direction D2 is between the position of the third partial region r3 in the second direction D2 and the position of the second partial region r2 in the second direction D2.

As shown in FIG. 11, the direction from the third partial region r3 to the sixth partial region r6 is along the first direction D1. As shown in FIG. 9, the direction from the seventh partial region r7 to the sixth partial region r6 is along the second direction D2.

The second semiconductor member 20 includes Alₓ₂Ga₁₋ₓ₂N (0 < x2 ≤ 1, x1 < x2). The second semiconductor member 20 includes the first semiconductor portion 21, the second semiconductor portion 22, and the third semiconductor portion 23.

As shown in FIG. 8, the direction from the fourth partial region r4 to the first semiconductor portion 21 is along the third direction D3. The direction from the fifth partial region r5 to the second semiconductor portion 22 is along the third direction D3. As shown in FIG. 9, the direction from the seventh partial region r7 to the third semiconductor portion 23 is along the third direction D3. As shown in FIG. 8, the first electrode portion 53a is provided between the first semiconductor portion 21 and the second semiconductor portion 22 in the second direction D2.

The crystallinity of the first semiconductor portion 21 is higher than the crystallinity of the third semiconductor portion 23. Alternatively, the first semiconductor portion 21 includes crystal, and the third semiconductor portion 23 does not include crystal. As shown in FIG. 9, the seventh partial region r7 and the third semiconductor portion 23 are included in the high resistance region 10i. The seventh partial region r7 and the third semiconductor portion 23 are included in the second region R2 (see FIG. 7).

As shown in FIGS. 8 and 11, the first insulating member 41 includes the first insulating portion 41a. The first insulating portion 41a is provided between the third partial region r3 and the first electrode portion 53a, between the first semiconductor portion 21 and the first electrode portion 53a, and between the first electrode portion 53a and the second semiconductor portion 22.

As shown in FIGS. 7 and 9, the second insulating member 42 includes the first insulating region 42a. The first insulating region 42a is provided between the third semiconductor portion 23 and the third electrode 53 in the second direction D2.

In the semiconductor device 120, the current path is divided by the first insulating region 42a. Leakage current is suppressed. A semiconductor device whose characteristics can be improved can be provided.

As shown in FIG. 9, the first semiconductor member 10 may further include an eighth partial region r8. The sixth partial region r6 is provided between the seventh partial region r7 and the eighth partial region r8 in the second direction D2. The second semiconductor member 20 may further include the fourth semiconductor portion 24. A direction from the eighth partial region r8 to the fourth semiconductor portion 24 is along the third direction D3.

At least a part of the eighth partial region r8 and the fourth semiconductor portion 24 are included in the high resistance region 10i. At least a part of the eighth partial region r8 and the fourth semiconductor portion 24 are included in the second region R2.

For example, the crystallinity of the second semiconductor portion 22 is higher than the crystallinity of the fourth semiconductor portion 24. Alternatively, the second semiconductor portion 22 includes crystal, and the fourth semiconductor portion 24 does not include crystal.

As shown in FIG. 9, the second insulating member 42 further includes the second insulating region 42b. The second insulating region 42b is provided between the third electrode 53 and the fourth semiconductor portion 24 in the second direction D2. The current path is more reliably divided by the second insulating region 42b. Leakage current is suppressed.

As shown in FIG. 10, the first semiconductor member 10 may further include a ninth partial region r9. As shown in FIG. 11, the third partial region r3 is provided between the ninth partial region r9 and the sixth partial region r6 in the first direction D1.

As shown in FIG. 10, the first semiconductor member 10 may further include a tenth partial region r10. A direction from the tenth partial region r10 to the ninth partial region r9 is along the second direction D2. The second semiconductor member 20 may further include a fifth semiconductor portion 25. A direction from the tenth partial region r10 to the fifth semiconductor portion 25 is along the third direction D3.

The second insulating member 42 may include a third insulating region 42c. The third insulating region 42c is provided between the fifth semiconductor portion 25 and the third electrode 53 in the second direction D2. The current path is more surely divided by the third insulating region 42c. Leakage current is suppressed.

As shown in FIG. 10, the first semiconductor member 10 may further include an eleventh partial region r11. In the second direction D2, the ninth partial region r9 is provided between the tenth partial region r10 and the eleventh partial region r11. The second semiconductor member 20 may further include a sixth semiconductor portion 26. A direction from the eleventh partial region r11 to the sixth semiconductor portion 26 is along the third direction D3.

The second insulating member 42 may include a fourth insulating region 42d. The fourth insulating region 42d is provided between the third electrode 53 and the sixth semiconductor portion 26 in the second direction D2. The current path is more reliably divided by the fourth insulating region 42d. Leakage current is suppressed.

At least a part of the tenth partial region r10 and the fifth semiconductor portion 25 are included in the high resistance region 10i. At least a part of the tenth partial region r10 and the fifth semiconductor portion 25 are included in the third region R3.

At least a part of the eleventh partial region r11 and the sixth semiconductor portion 26 are included in the high resistance region 10i. At least a part of the eleventh partial region r11 and the sixth semiconductor portion 26 are included in the third region R3.

For example, the crystallinity of the first semiconductor portion 21 is higher than the crystallinity of the fifth semiconductor portion 25. Alternatively, the first semiconductor portion 21 includes crystal, and the fifth semiconductor portion 25 does not include crystal. The crystallinity of the second semiconductor portion 22 is higher than the crystallinity of the sixth semiconductor portion 26. Alternatively, the second semiconductor portion 22 includes crystals and the sixth semiconductor portion 26 does not include crystal.

For example, the crystallinity of the ninth partial region r9 is higher than the crystallinity of the tenth partial region r10. Alternatively, the ninth partial region r9 includes crystal, and the tenth partial region r10 does not include crystal. For example, the crystallinity of the ninth partial region r9 is higher than the crystallinity of the eleventh partial region r11. Alternatively, the ninth partial region r9 includes crystal, and the eleventh partial region r11 does not include crystal.

As shown in FIG. 8, the semiconductor device 120 may include the first compound member 31 . The first compound member 31 includes Al_{z1}Ga_{1-z1}N (0 < z1 ≤ 1, x2 < z1). At least a part of the first compound member 31 is provided between the third partial region r3 and the first insulating portion 41a, between the first semiconductor portion 21 and the first insulating portion 41a, and between the first insulating portion 41a and the second semiconductor portion 22. By providing the first compound member 31, for example, high mobility is easily obtained. The resistance of the semiconductor device 120 can be lowered.

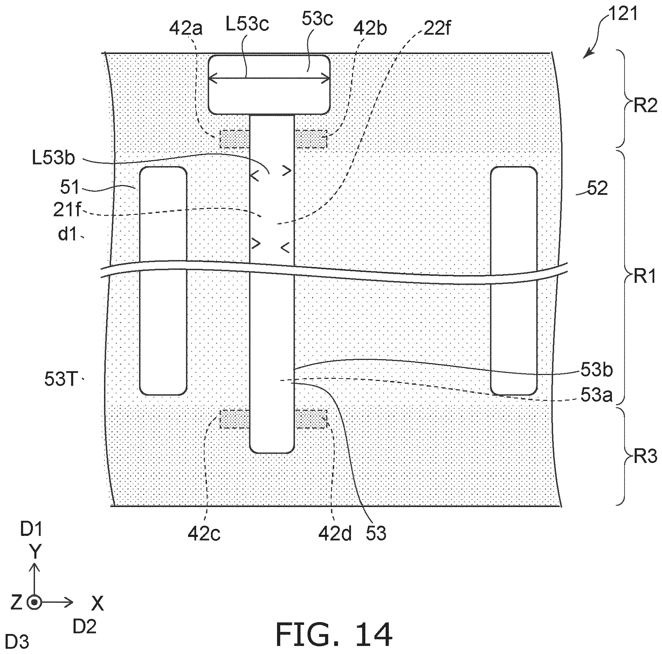

FIG. 14 is a schematic plan view illustrating a semiconductor device according to the second embodiment.

As shown in FIG. 14, in a semiconductor device 121 according to the embodiment, the third electrode 53 includes a third electrode portion 53c. Except for this, the configuration of the semiconductor device 121 may be the same as the configuration of the semiconductor device 120.

As shown in FIG. 14, the third electrode 53 includes the second electrode portion 53b and the third electrode portion 53c. As shown in FIG. 8, the first electrode portion 53a is provided between the third partial region r3 and the second electrode portion 53b in the third direction D3.

As shown in FIG. 14, the position of the first insulating region 42a in the first direction D1 is between the position of the first electrode portion 53a in the first direction D1 and the position of the third electrode portion 53c in the first direction D1. As shown in FIG. 14, a length of the third electrode portion 53c in the second direction D2 is defined as a third electrode portion length L53c. A length of the second electrode portion 53b in the second direction D2 is defined as the second electrode portion length L53b. The third electrode portion length L53c is longer than the second electrode portion length L53b. By providing such the third electrode portion 53c, the connection between the third electrode 53 and the wiring becomes easy.

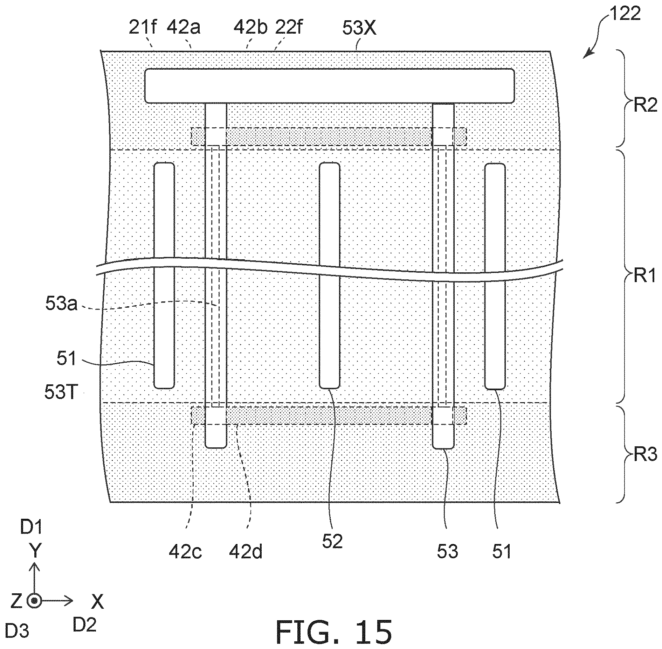

FIG. 15 is a schematic plan view illustrating a semiconductor device according to the second embodiment.

As shown in FIG. 15, in a semiconductor device 122 according to the embodiment, a plurality of third electrodes 53 are provided. Except for this, the configuration of the semiconductor device 122 may be the same as the configuration of the semiconductor device 120.

As shown in FIG. 15, in this example, the second insulating region 42b is continuously provided between one of the plurality of third electrodes 53 and another one of the plurality of third electrodes 53. The first insulating region 42a and the second insulating region 42b may be interchanged. In the embodiment, any one of the first insulating region 42a and the second insulating region 42b may be provided continuously between one of the plurality of third electrodes 53 and another one of the plurality of third electrodes 53.

As shown in FIG. 15, the semiconductor device 122 may further include a connecting conductive portion 53X. The connecting conductive portion 53X extends along the second direction D2. The position of the first insulating region 42a in the first direction D1 is between the position of the first electrode portion 53a in the first direction D1 and the position of the connecting conductive portion 53X in the first direction D1. For example, the plurality of third electrodes 53 are provided. The connecting conductive portion 53X electrically connects one of the plurality of third electrodes 53 to another one of the plurality of third electrodes 53.

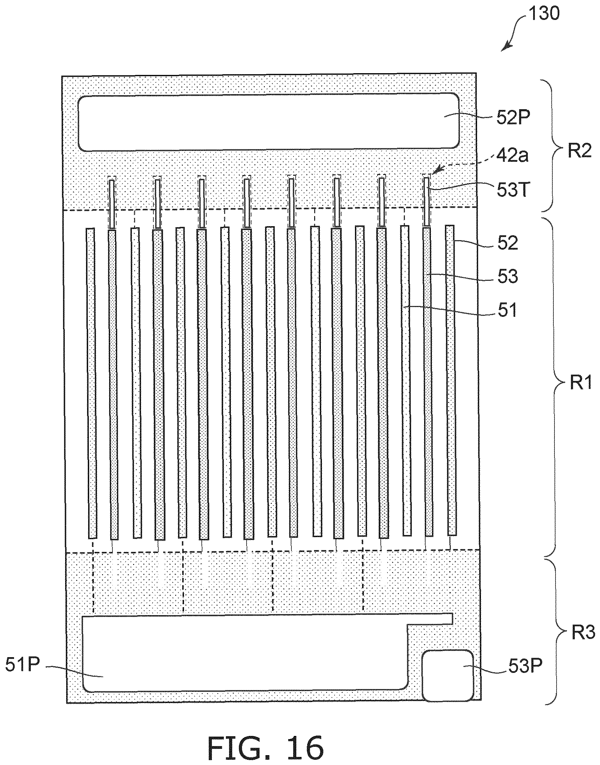

FIG. 16 is a schematic plan view illustrating a semiconductor device according to an embodiment.

As shown in FIG. 16, a semiconductor device 130 according to the embodiment includes a first electrode pad 51P, a second electrode pad 52P, and a third electrode pad 53P. The configuration of the semiconductor device 130 other than this may be the same as the configuration of any semiconductor device and its modification according to the first and second embodiments described above.

In the semiconductor device 130, a plurality of first electrodes 51, a plurality of second electrodes 52, and a plurality of third electrodes 53 are provided. The first electrode pad 51P is electrically connected to the plurality of first electrodes 51. The second electrode pad 52P is electrically connected to the plurality of second electrodes 52. The third electrode pad 53P is electrically connected to the plurality of third electrodes 53.

For example, the first electrode pad 51P and the third electrode pad 53P are provided in the third region R3. The second electrode pad 52P is provided in the second region R2.

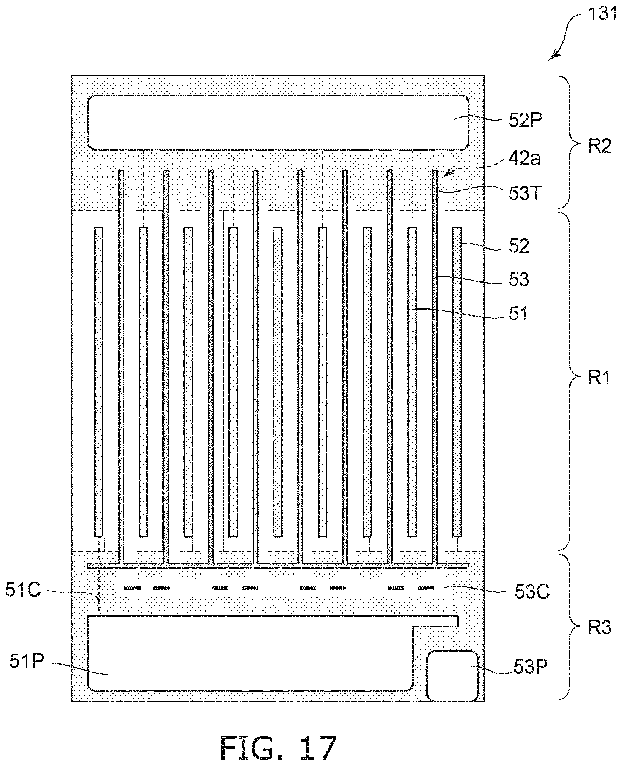

FIG. 17 is a schematic plan view illustrating a semiconductor device according to an embodiment.

As shown in FIG. 17, a semiconductor device 131 according to the embodiment includes a first electrode connecting portion 51C and a third electrode connecting portion 53C. The configuration of the semiconductor device 131 other than this may be the same as the configuration of the semiconductor device 130.

The first electrode connecting portion 51C and the third electrode connecting portion 53C extend along the second direction D2. The first electrode connecting portion 51C electrically connects the plurality of first electrodes 51. The third electrode connecting portion 53C electrically connects the plurality of third electrodes 53. In the semiconductor device 130 and the semiconductor device 131, as well, at least the first insulating region 42a is provided. Leakage current can be suppressed. A semiconductor device whose characteristics can be improved can be provided.

In embodiments, information regarding length and thickness is obtained, such as by electron microscopy. Information regarding the composition of the material can be obtained by SIMS (Secondary Ion Mass Spectrometry), EDX (Energy dispersive X-ray spectroscopy), or the like. Information regarding crystallinity can be obtained, such as by PL (Photo Luminescence).

Embodiments may include following technical proposals.

### (Technical proposal 1)

A semiconductor device, comprising:
a first electrode extending along a first direction;
a second electrode extending along the first direction, a second direction from the first electrode to the second electrode crossing the first direction;
a third electrode extending along the first direction, a position of the third electrode in the second direction being between a position of the first electrode in the second direction and a position of the second electrode in the second direction, the third electrode including a first electrode portion;
a first semiconductor member including Alₓ₁Ga₁₋ₓ₁N(0 ≤ x1 < 1), the first semiconductor member including a first partial region, a second partial region, a third partial region, a fourth partial region, a fifth partial region and a sixth partial region, a direction from the first partial region to the first electrode being along a third direction crossing a plane including the first direction and the second direction, a direction from the second partial region to the second electrode being along the third direction, a direction from the third partial region to the first electrode portion being along the third direction, a position of the fourth partial region in the second direction being between a position of the first partial region in the second direction and a position of the third partial region in the second direction, a position of the fifth partial region in the second direction being between the position of the third partial region in the second direction and a position of the second partial region in the second direction, a direction from the third partial region to the sixth partial region being along the first direction;
a second semiconductor member including Alₓ₂Ga₁₋ₓ₂N (0 < x2 ≤ 1, x1 < x2), the second semiconductor member including a first semiconductor portion, a second semiconductor portion and a third semiconductor portion, a direction from the fourth partial region to the first semiconductor portion being along the third direction, a direction from the fifth partial region to the second semiconductor portion being along the third direction, a direction from the sixth partial region to the third semiconductor portion being along the third direction, the first electrode portion being provided between the first semiconductor portion and the second semiconductor portion in the second direction, a direction from the first electrode portion to the third semiconductor portion being along the first direction;
a first insulating member including a first insulating portion, the first insulating portion being provided between the third partial region and the first electrode portion, between the first semiconductor portion and the first electrode portion, and between the first electrode portion and the second semiconductor portion; and
a second insulating member including a first insulating region, the first insulating region being provided between the third electrode and the third semiconductor portion in the first direction.

### (Technical proposal 2)

The semiconductor device according to Technical proposal 1, wherein
a crystallinity of the first semiconductor portion is higher than a crystallinity of the third semiconductor portion, or
the first semiconductor portion includes a crystal and the third semiconductor portion does not include a crystal.

### (Technical proposal 3)

The semiconductor device according to Technical proposal 1 or 2, wherein
a crystallinity of the fourth partial region is higher than a crystallinity of the sixth partial region, or
the fourth partial region includes a crystal and the sixth partial region does not include a crystal.

### (Technical proposal 4)

The semiconductor device according to any one of Technical proposals 1-3, wherein
the first semiconductor portion includes a first side face facing the first electrode portion,
the second semiconductor portion includes a second side face facing the first electrode portion, and
a first distance between the first side face and the second side face along the second direction is narrower than a first width of at least a part of the first insulating region along the second direction.

### (Technical proposal 5)

The semiconductor device according to Technical proposal 1, wherein
the first semiconductor member further includes a seventh partial region,
the third partial region is provided between the seventh partial region and the sixth partial region in the first direction,
the second semiconductor member further includes a fourth semiconductor portion,
the first electrode portion is provided between the fourth semiconductor portion and the third semiconductor portion in the first direction,
the second insulating member further includes a second insulating region, and
the second insulating region is provided between the fourth semiconductor portion and the third electrode in the first direction.

### (Technical proposal 6)

The semiconductor device according to Technical proposal 5, wherein
a crystallinity of the first semiconductor portion is higher than a crystallinity of the fourth semiconductor portion, or
the first semiconductor portion includes a crystal and the fourth semiconductor portion does not include a crystal.

### (Technical proposal 7)

The semiconductor device according to Technical proposal 5 or 6, wherein
a crystallinity of the fourth partial region is higher than a crystallinity of the seventh partial region, or
the fourth partial region includes a crystal and the seventh partial region does not include a crystal.

### (Technical proposal 8)

The semiconductor device according to any one of Technical proposals 5-7, wherein
the first semiconductor member includes a first region, a second region and a third region,
the first region is provided between the second region and the third region in the first direction,
the first partial region, the second partial region, the third partial region, the fourth partial region and the fifth partial region are included in the first region,
the sixth partial region is included in the second region,
the seventh partial region is included in the third region,
a crystallinity of the first region is higher than a crystallinity of the second region and higher than a crystallinity of the third region, or
the first region includes a crystal, and the second region and the third region do not include a crystal.

### (Technical proposal 9)

The semiconductor device according to Technical proposal 8, wherein
the third electrode does not overlap the second region in the third direction and does not overlap the third region in the third direction.

### (Technical proposal 10)

The semiconductor device according to Technical proposal 8 or 9, wherein
the second electrode does not overlap the second region in the third direction and does not overlap the third region in the third direction.

### (Technical proposal 11)

The semiconductor device according to any one of Technical proposals 5-10, wherein
the first semiconductor portion includes a first side face facing the first electrode portion,
the second semiconductor portion includes a second side face facing the first electrode portion, and
a first distance between the first side face and the second side face along the second direction is narrower than a second width of at least a part of the second insulating region along the second direction.

### (Technical proposal 12)

The semiconductor device according to any one of Technical proposals 1-11, wherein
a plurality of the third electrodes are provided,
a plurality of the first insulating regions are provided,
a direction from one of the plurality of third electrodes to one of the plurality of first insulating regions is along the first direction,
a direction from another one of the plurality of third electrodes to another one of the plurality of first insulating regions is along the first direction, and
in a first plane including the first direction and the second direction, the one of the plurality of first insulating regions is continuous with the other one of the plurality of first insulating regions.

### (Technical proposal 13)

The semiconductor device according to any one of Technical proposals 1-12, further comprising:
a third electrode connecting portion,
a plurality of the third electrodes being provided,
the third electrode connecting portion electrically connecting the plurality of third electrodes to each other.

### (Technical proposal 14)

The semiconductor device according to any one of Technical proposals 1-13, further comprising:
a first compound member including Al_{z1}Ga_{1-z1}N (0 < z1 ≤ 1, x2 < z1),
at least a part of the first compound member being provided between the third partial region and the first insulating portion, between the first semiconductor portion and the first insulating portion, and between the first insulating portion and the second semiconductor portion.

### (Technical proposal 15)

A semiconductor device, comprising:
a first electrode extending along a first direction;
a second electrode extending along the first direction, a second direction from the first electrode to the second electrode crossing the first direction;
a third electrode extending along the first direction, a position of the third electrode in the second direction being between a position of the first electrode in the second direction and a position of the second electrode in the second direction, the third electrode including a first electrode portion;
a first semiconductor member including Alₓ₁Ga₁₋ₓ₁N(0 ≤ x1 < 1), the first semiconductor member including a first partial region, a second partial region, a third partial region, a fourth partial region, a fifth partial region, a sixth partial region and a seventh partial region, a direction from the first partial region to the first electrode being along a third direction crossing a plane including the first direction and the second direction, a direction from the second partial region to the second electrode being along the third direction, a direction from the third partial region to the first electrode portion being along the third direction, a position of the fourth partial region in the second direction being between a position of the first partial region in the second direction and a position of the third partial region in the second direction, a position of the fifth partial region in the second direction being between the position of the third partial region in the second direction and a position of the second partial region in the second direction, a direction from the third partial region to the sixth partial region being along the first direction, a direction from the seventh partial region to the sixth partial region being along the second direction;
a second semiconductor member including Alₓ₂Ga₁₋ₓ₂N (0 < x2 ≤ 1, x1 < x2), the second semiconductor member including a first semiconductor portion, a second semiconductor portion and a third semiconductor portion, a direction from the fourth partial region to the first semiconductor portion being along the third direction, a direction from the fifth partial region to the second semiconductor portion being along the third direction, a direction from the seventh partial region to the third semiconductor portion being along the third direction, the first electrode portion being provided between the first semiconductor portion and the second semiconductor portion in the second direction, a crystallinity of the first semiconductor portion being higher than a crystallinity the third semiconductor portion, or the first semiconductor portion including a crystal and the third semiconductor portion not including a crystal;
a first insulating member including a first insulating portion, the first insulating portion being provided between the third partial region and the first electrode portion, between the first semiconductor portion and the first electrode portion, and between the first electrode portion and the second semiconductor portion; and
a second insulating member including a first insulating region, the first insulating region being provided between the third semiconductor portion and the third electrode in the first direction.

### (Technical proposal 16)

The semiconductor device according to Technical proposal 15, wherein
the first semiconductor member further includes an eighth partial region,
the sixth partial region is provided between the seventh partial region and the eighth partial region in the second direction,
the second semiconductor member further includes a fourth semiconductor portion,
a direction from the eighth partial region to the fourth semiconductor portion is along the third direction,
a crystallinity of the second semiconductor portion is higher than a crystallinity of the fourth semiconductor portion, or the second semiconductor portion includes a crystal and the fourth semiconductor portion does not include a crystal,
the second insulating member further includes a second insulating region, and
the second insulating region is provided between the third electrode and the fourth semiconductor portion in the second direction.

### (Technical proposal 17)

The semiconductor device according to Technical proposal 15 or 16, wherein
the third electrode further includes a second electrode portion and a third electrode portion,
the first electrode portion is provided between the third partial region and the second electrode portion in the third direction,
a position of the first insulating region in the first direction is between a position of the first electrode portion in the first direction and a position of the third electrode portion in the first direction, and
a third electrode portion length of the third electrode portion in the second direction is longer than a second electrode portion length of the second electrode portion in the second direction.

### (Technical proposal 18)

The semiconductor device according to Technical proposal 16, wherein
a plurality of the third electrodes are provided, and
one of the first insulating region and the second insulating region is continuously provided between one of the plurality of third electrodes and another one of the plurality of third electrodes.

### (Technical proposal 19)

The semiconductor device according to Technical proposal 15, further comprising:
a connecting conductive portion extending along the second direction,
a position of the first insulating region in the first direction being between a position of the first electrode portion in the first direction and a position of the connecting conductive portion in the first direction, and
a plurality of the third electrodes being provided, and
the connecting conductive portion electrically connecting one of the plurality of third electrodes to another one of the plurality of third electrodes.

### (Technical proposal 20)

The semiconductor device according to Technical proposal 15 or 16, further comprising:
a first compound member including Al_{z1}Ga_{1-z1}N (0 < z1 ≤ 1, x2 < z1),
at least a part of the first compound member being provided between the third partial region and the first insulating portion, between the first semiconductor portion and the first insulating portion, and between the first insulating portion and the second semiconductor portion.

According to the embodiment, a semiconductor device with improved characteristics can be provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in the semiconductor devices such as semiconductor members, electrodes, insulating members, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all semiconductor devices practicable by an appropriate design modification by one skilled in the art based on the semiconductor devices described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device, comprising:
a first electrode (51) extending along a first direction (D1);
a second electrode (52) extending along the first direction (D1), a second direction (D2) from the first electrode (51) to the second electrode (52) crossing the first direction (D1);
a third electrode (53) extending along the first direction (D1), a position of the third electrode (53) in the second direction (D2) being between a position of the first electrode (51) in the second direction (D2) and a position of the second electrode (52) in the second direction (D2), the third electrode (53) including a first electrode portion (53a);
a first semiconductor member (10) including Alₓ₁Ga₁₋ₓ₁N(0 < x1 < 1), the first semiconductor member including a first partial region (r1), a second partial region (r2), a third partial region (r3), a fourth partial region (r4), a fifth partial region (r5) and a sixth partial region (r6), a direction from the first partial region (r1) to the first electrode (51) being along a third direction (D3) crossing a plane including the first direction (D1) and the second direction (D2), a direction from the second partial region (r2) to the second electrode (52) being along the third direction (D3), a direction from the third partial region (r3) to the first electrode portion (53a) being along the third direction (D3), a position of the fourth partial region (r4) in the second direction (D2) being between a position of the first partial region (r1) in the second direction (D2) and a position of the third partial region (r3) in the second direction (D2), a position of the fifth partial region (r5) in the second direction (D2) being between the position of the third partial region (r3) in the second direction (D2) and a position of the second partial region (r2) in the second direction (D2), a direction from the third partial region (r3) to the sixth partial region (r6) being along the first direction (D1);
a second semiconductor member (20) including Alₓ₂Ga₁₋ₓ₂N (0 < x2 ≤ 1, x1 < x2), the second semiconductor member including a first semiconductor portion (21), a second semiconductor portion (22) and a third semiconductor portion (23), a direction from the fourth partial region (r4) to the first semiconductor portion (21) being along the third direction (D3), a direction from the fifth partial region (r5) to the second semiconductor portion (22) being along the third direction (D3), a direction from the sixth partial region (r6) to the third semiconductor portion (23) being along the third direction (D3), the first electrode portion (53a) being provided between the first semiconductor portion (21) and the second semiconductor portion (22) in the second direction (D2), a direction from the first electrode portion (21) to the third semiconductor portion (23) being along the first direction D1;
a first insulating member (41) including a first insulating portion (41a), the first insulating portion being provided between the third partial region (r3) and the first electrode portion (53a), between the first semiconductor portion (21) and the first electrode portion (53a), and between the first electrode portion (53a) and the second semiconductor portion (22); and
a second insulating member (42) including a first insulating region (42a), the first insulating region (42a) being provided between the third electrode (53) and the third semiconductor portion (23) in the first direction (D1).

2. The device according to claim 1, wherein
a crystallinity of the first semiconductor portion (21) is higher than a crystallinity of the third semiconductor portion (23), or
the first semiconductor portion (21) includes a crystal and the third semiconductor portion (23) does not include a crystal.

3. The device according to claim 1 or 2, wherein
a crystallinity of the fourth partial region (r4) is higher than a crystallinity of the sixth partial region (r6), or
the fourth partial region (r4) includes a crystal and the sixth partial region (r6) does not include a crystal.

4. The device according to any one of claims 1 to 3, wherein
the first semiconductor portion (21) includes a first side face (21f) facing the first electrode portion (53a),
the second semiconductor portion (22) includes a second side face (22f) facing the first electrode portion (53a), and
a first distance (d1) between the first side face and the second side face along the second direction (D2) is narrower than a first width (L1) of at least a part of the first insulating region (42a) along the second direction (D2).

5. The device according to claim 1, wherein
the first semiconductor member (10) further includes a seventh partial region (r7),
the third partial region (r3) is provided between the seventh partial region (r7) and the sixth partial region (r6) in the first direction D1),
the second semiconductor member further includes a fourth semiconductor portion (24),
the first electrode portion (53a) is provided between the fourth semiconductor portion (24) and the third semiconductor portion (23) in the first direction (D1),
the second insulating member (42) further includes a second insulating region (42b), and
the second insulating region (42b) is provided between the fourth semiconductor portion (24) and the third electrode (53) in the first direction (D1).

6. The device according to claim 5, wherein
a crystallinity of the first semiconductor portion (21) is higher than a crystallinity of the fourth semiconductor portion (24), or
the first semiconductor portion includes a crystal and the fourth semiconductor portion does not include a crystal.

7. The device according to claim 5 or 6, wherein
a crystallinity of the fourth partial region (r4) is higher than a crystallinity of the seventh partial region (r7), or
the fourth partial region includes a crystal and the seventh partial region does not include a crystal.

8. The device according to any one of claims 5 to 7, wherein
the first semiconductor member includes a first region (R1), a second region (R2) and a third region (R3),
the first region (R1) is provided between the second region (R2) and the third region (R3) in the first direction (D1),
the first partial region (r1), the second partial region (r2), the third partial region (r3), the fourth partial region (r4) and the fifth partial region (r5) are included in the first region (R1),
the sixth partial region (r6) is included in the second region (R2),
the seventh partial region (r7) is included in the third region (R3),
a crystallinity of the first region is higher than a crystallinity of the second region and higher than a crystallinity of the third region, or
the first region includes a crystal, and the second region and the third region do not include a crystal.

9. The device according to claim 8, wherein
the third electrode (53) does not overlap the second region (R2) in the third direction (D3) and does not overlap the third region (R3) in the third direction (D3).

10. The device according to claim 8 or 9, wherein
the second electrode (52) does not overlap the second region (R2) in the third direction (D3) and does not overlap the third region (R3) in the third direction (D3).

11. The device according to any one of claims 5 to 10, wherein
the first semiconductor portion (21) includes a first side face (21f) facing the first electrode portion (53a),
the second semiconductor portion (22) includes a second side face (22f) facing the first electrode portion (53a), and
a first distance (d1) between the first side face and the second side face along the second direction (D2) is narrower than a second width (L2) of at least a part of the second insulating region (42b) along the second direction (D2).

12. The device according to any one of claims 1 to 11, wherein
a plurality of the third electrodes (53) are provided,
a plurality of the first insulating regions (42a) are provided,
a direction from one of the plurality of third electrodes to one of the plurality of first insulating regions is along the first direction (D1),
a direction from another one of the plurality of third electrodes to another one of the plurality of first insulating regions is along the first direction (D1), and
in a first plane including the first direction (D1) and the second direction (D2), the one of the plurality of first insulating regions (42a) is continuous with the other one of the plurality of first insulating regions (42a).

13. The device according to any one of claims 1 to 12, further comprising:
a third electrode connecting portion (53C),
a plurality of the third electrodes (53) being provided,
the third electrode connecting portion (53C) electrically connecting the plurality of third electrodes (53) to each other.

14. The device according to any one of claims 1 to 13, further comprising:
a first compound member (31) including Al_{z1}Ga_{1-z1}N (0 < z1 ≤ 1, x2 < z1),
at least a part of the first compound member being provided between the third partial region (r3) and the first insulating portion (42a), between the first semiconductor portion (21) and the first insulating portion (42a), and between the first insulating portion (42a) and the second semiconductor portion (22).

15. A semiconductor device, comprising:
a first electrode (51) extending along a first direction (D1);
a second electrode (52) extending along the first direction (D1), a second direction (D2) from the first electrode (51) to the second electrode (52) crossing the first direction (D1);
a third electrode (53) extending along the first direction (D1), a position of the third electrode (53) in the second direction (D2) being between a position of the first electrode (51) in the second direction (D2) and a position of the second electrode (52) in the second direction (D2), the third electrode including a first electrode portion (53a);
a first semiconductor member (10) including Alₓ₁Ga₁₋ₓ₁N(0 ≤ x1 < 1), the first semiconductor member including a first partial region (r1), a second partial region (r2), a third partial region (r3), a fourth partial region (r4), a fifth partial region (r5), a sixth partial region (r6) and a seventh partial region (r7), a direction from the first partial region (r1) to the first electrode being along a third direction (D3) crossing a plane including the first direction (D1) and the second direction (D2), a direction from the second partial region (r2) to the second electrode being along the third direction (D3), a direction from the third partial region (r3) to the first electrode portion being along the third direction (D3), a position of the fourth partial region (r4) in the second direction (D2) being between a position of the first partial region (r1) in the second direction (D2) and a position of the third partial region (r3) in the second direction (D2), a position of the fifth partial region (r5) in the second direction (D2) being between the position of the third partial region (r3) in the second direction (D2) and a position of the second partial region (r2) in the second direction (D2), a direction from the third partial region (r3) to the sixth partial region (r6) being along the first direction (D1), a direction from the seventh partial region (r7) to the sixth partial region (r6) being along the second direction (D2);
a second semiconductor member (20) including Alₓ₂Ga₁₋ₓ₂N (0 < x2 ≤ 1, x1 < x2), the second semiconductor member including a first semiconductor portion (21), a second semiconductor portion (22) and a third semiconductor portion (23), a direction from the fourth partial region (r4) to the first semiconductor portion (21) being along the third direction (D3), a direction from the fifth partial region (r5) to the second semiconductor portion (22) being along the third direction (D3), a direction from the seventh partial region (r7) to the third semiconductor portion (23) being along the third direction (D3), the first electrode portion being provided between the first semiconductor portion (21) and the second semiconductor portion (22) in the second direction (D2), a crystallinity of the first semiconductor portion (21) being higher than a crystallinity the third semiconductor portion (23), or the first semiconductor portion (21) including a crystal and the third semiconductor portion (23) not including a crystal;
a first insulating member (41) including a first insulating portion (41a), the first insulating portion (41a) being provided between the third partial region (r3) and the first electrode portion (53a), between the first semiconductor portion (21) and the first electrode portion (53a), and between the first electrode portion (53a) and the second semiconductor portion (22); and
a second insulating member (42) including a first insulating region (42a), the first insulating region (42a) being provided between the third semiconductor portion (23) and the third electrode (53) in the first direction (D1).
